(19) Europäisches Patentamt
European Patent Office
Office européen des brevets

(11) **EP 0 786 843 B1**

(12) **FASCICULE DE BREVET EUROPEEN**

(45) Date de publication et mention
de la délivrance du brevet:
**21.06.2000 Bulletin 2000/25**

(51) Int Cl.⁷: **H01S 5/40**, H01S 5/10

(21) Numéro de dépôt: **97400174.5**

(22) Date de dépôt: **27.01.1997**

(54) **Composant d'émission laser multilongueur d'onde**

Mehrfachwellenlängen-Laser-Emissionsbauelement

Multiwavelength laser emission component

(84) Etats contractants désignés:
**DE GB**

(30) Priorité: **29.01.1996 FR 9600988**

(43) Date de publication de la demande:
**30.07.1997 Bulletin 1997/31**

(73) Titulaire: **FRANCE TELECOM**
**75015 Paris (FR)**

(72) Inventeur: **Menigaux, Louis**
**91440 Bures sur Yvette (FR)**

(74) Mandataire: **Martin, Jean-Jacques et al**
**Cabinet REGIMBEAU**
**26, Avenue Kléber**
**75116 Paris (FR)**

(56) Documents cités:
**EP-A- 0 361 399** **US-A- 5 384 797**

- **JOURNAL OF VACUUM SCIENCE AND TECHNOLOGY: PART B, vol. 13, no. 6, Novembre 1995, NEW YORK US, pages 2722-2724, XP000558345 I.M. TEMPLETON ET AL.: "FOCUSED ION BEAM LITHOGRAPHY OF MULTIPERIOD GRATINGS FOR A WAVELENGTH-DIVISION-MULTIPLEXED TRANSMITTER LASER ARRAY"**
- **JOURNAL OF LIGHTWAVE TECHNOLOGY, vol. 9, no. 12, Décembre 1991, NEW YORK US, pages 1665-1673, XP000275434 C.J.CHANG-HASNAIN ET AL.: "MONOLITHIC MULTIPLE WAVELENGTH SURFACE EMITTING LASER ARRAYS"**
- **JOURNAL OF VACUUM SCIENCE AND TECHNOLOGY: PART B, vol. 11, no. 6, Novembre 1993, NEW YORK US, pages 2509-2513, XP000423405 D.M. TENNANT ET AL.: "MULTIWAVELENGTH DISTRIBUTED BRAGG REFLECTOR LASER ARRAY FABRICATED USING NEAR FIELD HOLOGRAPHIC PRINTING WITH AN ELECTRON-BEAM GENERATED PHASE GRATING MASK"**
- **OPTOELECTRONICS DEVICES AND TECHNOLOGIES, vol. 9, no. 2, Juin 1994, TOKYO JP, pages 153-166, XP000455298 C. ZAH ET AL.: "MONOLITHIC INTEGRATED MULTIWAVELENGTH LASER ARRAYS FOR WDM LIGHTWAVE SYSTEMS"**
- **ELECTRONICS LETTERS, vol. 29, no. 25, 9 Décembre 1993, STEVENAGE GB, pages 2195-2197, XP000424140 Y. KATOH ET AL.: "DBR LASER ARRAY FOR WDM SYSTEM"**

## Description

La présente invention est relative à un composant d'émission laser multi-longueur d'onde.

Elle trouve en particulier avantageusement application au multiplexage en longueur d'onde pour les télécommunications optiques.

On connaît depuis plusieurs années des sources d'émission laser accordables en longueur d'onde, notamment des sources lasers à réflecteurs de Bragg distribués (lasers DBR selon la terminologie anglo-saxonne généralement utilisée par l'Homme du Métier).

On pourra par exemple à cet égard se référer à la publication :

[1] "High performance tunable 1.5 µm InGaAs/ InGaAsP multiple quantum well distributed Bragg reflector lasers" - T.L. Koch, U. Koren, and B.I. Miller - Applied Physics Letters 53 (12), 1988, p. 1036, ainsi qu'à

[2] "Focused ion beam lithography of multiperiod gratings for a wavelength-division-multiplexed transmitter laser array", I.M. Templeton et al., Journal of Vacuum Science and Technology, Part B, Vol. 13, n° 6, Novembre 1995, pages 2722-2724.

La réalisation de ces composants nécessite toutefois la mise en oeuvre de plusieurs reprises d'épitaxie et est donc complexe.

On connaît par ailleurs, notamment par US 4 993 036, des composants d'émission laser intégrant sur un même substrat une pluralité de sources d'émission laser présentant des réseaux de Bragg de périodes différentes.

Toutefois, la réalisation à l'échelle micrométrique d'une pluralité de réseaux de pas différents disposés les uns à côté des autres est technologiquement compliquée.

Plus récemment, il a été proposé, notamment dans la publication :

[3] "Control of lasing wavelength in distributed feedback lasers by angling the active stripe with respect to the grating" - W.T. Tsang, R.M. Kapre, R.A. Logan and T. Tanbun-Ek - IEEE PHOTONICS TECHNOLOGY LETTERS - Vol. 5, N° 9, 1993, pp. 978-980,

un composant comportant sur un même substrat d'une part un réseau de Bragg à pas constant et d'autre part une pluralité de rubans enterrés formant couches actives d'émission laser, ces différents rubans étant inclinés selon des angles différents par rapport au réseau de diffraction.

La longueur d'onde d'émission des différentes sources ainsi constituées varie avec l'angle d'inclinaison entre leur ruban formant couche active et le réseau de diffraction.

Toutefois, ces composants posent des problèmes de fibrage.

Les matériaux employés pour leur fabrication présentent en effet des indices de réfraction de l'ordre de 3,5. Etant donné que les différents rubans formant couches actives présentent des inclinaisons différentes par rapport au plan de clivage du substrat, il résulte de la réfraction des variations importantes des angles de sortie dans l'air des faisceaux émis par rapport à la normale au plan de clivage du composant.

Il est donc nécessaire de prévoir une inclinaison de fibre pour chaque longueur d'onde émise.

Un but de l'invention est de proposer un composant d'émission laser à plusieurs longueurs d'onde qui permet de s'affranchir de ces différents inconvénients.

Selon l'invention, ce but est atteint avec un composant d'émission laser multi-longueur d'onde présentant une pluralité de sources d'émission laser à réseau de Bragg, caractérisé en ce que les réseaux de Bragg desdites sources correspondent à un réseau de diffraction commun aux différentes sources, dont le pas varie de façon continue d'une source à l'autre.

Un tel dispositif comporte un seul réseau de diffraction.

Il est d'une réalisation simplifiée.

Il est en outre d'un fibrage aisé.

D'autres caractéristiques et avantages de l'invention ressortiront encore de la description qui suit. Cette description est purement illustrative et non limitative. Elle doit être lue en regard des dessins annexés sur lesquels :

- la figure 1 est une représentation schématique en vue de dessus d'un composant d'émission laser conforme à un mode de réalisation possible pour l'invention ;
- la figure 2 une représentation en perspective avec arraché du composant de la figure 1.

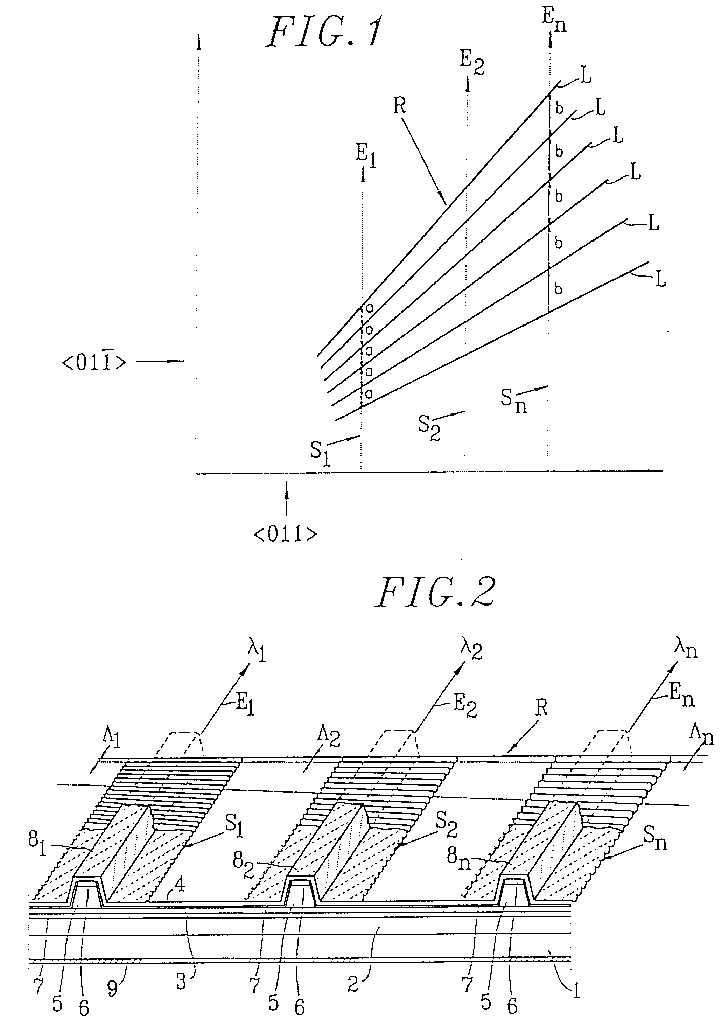

Le composant illustré sur les figures 1 et 2 présente une pluralité de sources $S_1$, $S_2$,...,$S_n$ d'émission laser à contre-réaction distribuée (DFB ou Distributed Feedback selon la terminologie anglo-saxonne généralement utilisée), qui présentent un réseau de diffraction commun R, dont le pas varie de façon continue d'une source à l'autre.

Dans le mode de réalisation particulièrement avantageux qui est illustré sur les figures 1 et 2, ce réseau de diffraction commun est en éventail.

On a représenté sur la figure 1 les lignes L de ce réseau de diffraction commun R, ainsi que les différentes directions d'émission $E_1$, $E_2$,..., $E_n$ des sources $S_1$, $S_2$,..., $S_n$.

Ces différentes lignes L du réseau R sont réparties de telle façon qu'elles définissent au niveau de chaque source $S_1$, $S_2$,..., $S_n$, un réseau périodique.

On notera en effet que, par application du théorème de Thalès, si au droit de la direction d'émission de l'une des sources, deux lignes L successives sont espacées d'une distance constante, il en est de même au droit des directions d'émission des autres sources, dès lors que les différentes directions d'émission $E_1$, $E_2$,..., $E_n$ des sources $S_1$, $S_2$,.., $S_n$ du composant sont parallèles entre elles. Sur la figure 1, deux lignes successives du réseau sont espacées d'une distance constante a dans la direction d'émission $E_1$. Par conséquent, dans la direction d'émission $E_n$ parallèle à la direction $E_1$, la distance entre deux lignes successives est également constante.

Les pas $\Lambda$ des réseaux de diffraction périodiques ainsi définis par le réseau commun R au niveau de chaque source $S_1$, $S_2$,.., $S_n$ sont bien entendu différents d'une source à l'autre.

L'angle entre deux lignes successives du réseau R, ainsi que les directions d'émission $E_1$, $E_2$,..., $E_n$ sont choisis en fonction des longueurs d'onde de Bragg $\lambda_{b1}$, $\lambda_{b2}$,.., $\lambda_{bn}$ souhaitées pour les différentes sources du composant.

On rappelle que la longueur d'onde de Bragg $\lambda_b$ d'une source d'émission laser DFB est reliée au pas $\Lambda$ de son réseau périodique par la relation

$$\lambda_b = 2n_{eff} \, \Lambda/m$$

où $n_{eff}$ est l'indice effectif du guide d'onde et m l'ordre de diffraction du réseau.

Pour une source donnée, la contre-réaction est sélective en longueur d'onde au voisinage de sa longueur d'onde de Bragg.

A titre d'exemple de réalisation, le composant selon l'invention peut être un composant du type de celui décrit dans US-4 993 036, dont les différents réseaux de Bragg sont constitués par un réseau de Bragg commun du type du réseau R qui vient d'être décrit.

Un composant en ce sens a été illustré sur la figure 2.

Il comporte un substrat 1 de GaAs dopé n+ d'épaisseur de l'ordre de 100 μm sur lequel est déposée une couche de confinement 2 en $Al_{0,5}Ga_{0,5}As$, une couche active 3 de 0,1 μm d'épaisseur, ainsi qu'une couche guide 4, également de 0,1 μm d'épaisseur.

Le réseau de diffraction R en éventail est réalisé par insolation sur la face supérieure entière de la couche 4, en prenant comme référence d'orientation pour les lignes du réseau les plans de clivage (O, 1, -1) et (0, 1, 1) du substrat 1 lorsque celui-ci est orienté selon le plan (1, 0, 0) (voir figure 1).

Le réseau est par exemple gravé ligne par ligne, l'échantillon étant pour chaque ligne déplacé en translation sous un faisceau d'insolation. A cet effet, l'échantillon est monté sur un porte échantillon qui est mobile, d'une part en translation sous le faisceau d'insolation, et d'autre part en rotation autour du point de jonction des différentes lignes du réseau.

Pour chaque gravure d'une ligne, le porte échantillon est fixe en rotation et se translate sous le faisceau. A l'issue d'une gravure, le porte échantillon est déplacé angulairement sur la position permettant la gravure de la ligne suivante, et ainsi de suite.

Sur la couche guide 4 ainsi gravée, une nouvelle couche de confinement 5 de $Al_{0,5}Ga_{0,5}As$ (confinement supérieur de type p) est déposée, puis une couche 6 de GaAs de type p dite de contact est à son tour déposée. L'empilement des couches 5 et 6 est taillé sous forme de ruban jusqu'au réseau. Une couche 7 isolante électriquement est déposée de part et d'autre de chaque ruban. Enfin, chaque ruban reçoit une électrode $8_1$, $8_2$,..., $8_n$: ces électrodes sont isolées électriquement les unes des autres.

Un contact ohmique 9 est réalisé sur la semelle. Après clivage selon des plans perpendiculaires aux rubans, on délimite des barrettes de diodes.

Les différents rubans d'émission ainsi définis sont tous parallèles, par exemple perpendiculaires à l'un des plans de clivage du substrat 1 (plan (0, 1, 1) sur la figure 1).

Bien entendu, l'enseignement de la présente invention n'est pas limité à ce composant particulier mais s'applique de façon générale aux barrettes multilongueur d'onde, dont les sources sont à réseaux de Bragg.

## Revendications

1.  Composant d'émission laser multi-longueur d'onde présentant une pluralité de sources d'émission laser ($S_1$, $S_2$,..., $S_n$) à réseau de Bragg, caractérisé en ce que les réseaux de Bragg desdites sources correspondent à un réseau de diffraction (R) commun aux différentes sources ($S_1$, $S_2$,..., $S_n$), dont le pas varie de façon continue d'une source à l'autre.

2.  Composant selon la revendication 1, caractérisé en ce que le réseau de diffraction (R) est en éventail, les directions d'émission ($E_1$, $E_2$,..., $E_n$) des différentes sources étant parallèles entre elles et sécantes aux lignes (L) du réseau de diffraction.

3.  Composant selon l'une des revendications 1 ou 2, caractérisé en ce que les sources d'émission laser ($S_1$, $S_2$,..., $S_n$) sont du type à contre-réaction distribuée.

4.  Application du composant selon l'une des revendications précédentes au multiplexage en longueur d'onde pour les télécommunications optiques.

## Patentansprüche

1.  Bauelement für die Emission von Mehrfachwellenlängen-Lasern mit einer Vielzahl von Emissionsquellen für Laserstrahlen ($S_1$, $S_2$, ...., $S_n$) mit einem

Bragg-Gitter,
**dadurch gekennzeichnet, daß**
die Bragg-Gitter dieser Emissionsquellen einem Beugungsgitter (R) entsprechen, das die verschiedenen Emissionsquellen ($S_1$, $S_2$, ....., $S_n$) gemeinsam haben und deren Kanalabstand zwischen den einzelnen Quellen kontinuierlich variiert.

**2.** Bauelement nach Anspruch 1,
**dadurch gekennzeichnet, daß**
das Beugungsgitter (R) fächerförmig konzipiert ist, und die Richtungen der Emission ($E_1$, $E_2$, ...., $E_n$) der verschiedenen Quellen untereinander parallel verlaufen und die Linien (L) des Beugungsgitters schneiden.

**3.** Bauelement nach einem der Ansprüche 1 oder 2,
**dadurch gekennzeichnet, daß**
die Laser-Emissionsquellen ($S_1$, $S_2$, ...., $S_n$) von der Art einer verteilten Rückkopplung sind.

**4.** Verwendung des Bauelementes nach einem der vorausgegangenen Ansprüche für den Multiplexbetrieb im Wellenlängenbereich für die optische Telekommunikation.

**Claims**

**1.** A multi-wavelength laser-emitting component presenting a plurality of Bragg grating laser-emitting sources ($S_1$, $S_2$, ..., $S_n$), the component being characterized in that the Bragg gratings of said sources correspond to a diffraction grating (R) common to the various sources ($S_1$, $S_2$, ..., $S_n$), with the pitch thereof varying continuously from one source to another.

**2.** A component according to claim 1, characterized in that the diffraction grating (R) is fan-shaped, the emission directions ($E_1$, $E_2$, ..., $E_n$) of the various sources being parallel to one another and intersecting the lines (L) of the diffraction grating.

**3.** A component according to claim 1 or 2, characterized in that the laser-emitting sources ($S_1$, $S_2$, ..., $S_n$) are of the distributed feedback type.

**4.** The use of a component according to any preceding claim in wavelength multiplexing for optical telecommunications.

# FIG.1

# FIG.2